# EUROPEAN PATENT APPLICATION

(11) **EP 2 061 076 A1**
(43) Date of publication of application: **20.05.2009**
(21) Application number: 08157942.7
(22) Date of filing: 10.06.2008
(51) Int. Cl.: H01L 21/8238, H01L 27/092

(54) **Dual work function device with stressor layer and method for manufacturing the same**

(30) Priority: 13.11.2007 US 987712 P
(71) Applicant: INTERUNIVERSITAIR MICRO-ELEKTRONICA CENTRUM VZW, 3001 Leuven (BE); Taiwan Semiconductor Manufacturing Company, Ltd. (TSMC), Hsinchu 300-077 (TW)
(72) Inventor: Chang, Shou-Zen, Hsinchu Country 310 (TW); Hoffmann, Thomas Y., 3000 Leuven (BE); Pourtois, Geoffrey, 1495 Villers-la-Ville (BE); Yu, Hong Yu, 639798 Singapore (SG)
(74) Representative: Bird, William Edward

(57) **Abstract**

The present invention provides a method for manufacturing a dual work function semiconductor device, comprising: providing a substrate comprising a first region and a second region, forming a gate dielectric (2) overlying the first and the second region, forming a metal gate layer (3) overlying the gate dielectric, the metal gate layer having a first (as-deposited) work function that can be modified upon inducing strain thereon selectively forming a first strained conductive layer (4) overlying the metal gate layer on the first region, the first strained conductive layer exerting a selected strain on the metal gate layer, thereby inducing a first pre-determined work function shift (ΔWF1) in the first (as-deposited) work function of metal gate layer on the first region.
A dual work function semiconductor device obtainable by the above method is also described.

## Description

### Field of the Invention

The present invention is related to methods of manufacturing CMOS devices. Particularly, the invention is related to CMOS-devices having a gate stack comprising a metal gate electrode.

### Description of the Related Technology

Scaling MOSFET transistors to improve performance results in higher gate leakage as the Si02 gate dielectric becomes thinner. To address this issue, Si02 gate dielectric has been replaced with high-k materials (k-value > kSi02). With the introduction of the high-k materials a new problem aroused, namely the Fermi level pinning. Fermi level pinning effect takes place at the polysilicon (polySi)/metal oxide interface and causes high threshold voltages in MOSFET devices.

A known solution to this problem is the introduction of metal gates. However, it has been proven difficult to identify band-edge metals (metals with either a n-type or a p-type work function (WF)) that are compatible with the conventional CMOS manufacturing process. CMOS can be made using dual metal gates with single or dual dielectrics. In either case, a selective removal of one of the metal gates is necessary and adds substantial complexity and costs to the manufacturing process.

Another known solution for CMOS manufacturing is to use Fully Silicided (FUSI) gates, without a selective removal of electrode or gate dielectric. However, FUSI gates require different silicide phases on nMOS and pMOS. on small devices, the phase or composition of the FUSI gates tends to distribute unevenly, resulting in severe within-wafer threshold voltage (Vₜ) non-uniformity.

### Summary of ther invention

One inventive aspect discloses a method for manufacturing a dual work function semiconductor device using strained conductive layers for work function tuning.

Another inventive aspect provides a method for manufacturing a dual work function semiconductor device which overcomes at least one of the drawbacks of prior art methods. Still another inventive aspect relates to a dual work function semiconductor device with good performance.

The present invention provides a method for manufacturing a dual work function semiconductor device comprising: providing a substrate with a first and a second region, forming a gate dielectric overlying the first and the second region, forming a metal gate layer overlying the gate dielectric, the metal gate layer having a first (as-deposited) work function that can be modified upon inducing strain thereon, selectively forming a first strained conductive layer, overlying the metal gate layer on the first region, the first strained conductive layer exerting a selected strain on the metal gate layer, thereby inducing a first pre-determined work function shift (ΔWF1) in the first (as-deposited) work function of the metal gate layer on the first region.

The method according to the above, wherein selectively forming a first strained conductive layer comprises: depositing a layer of polysilicon overlying the metal gate layer on the first and the second region, patterning the polysilicon, the metal gate layer and the gate dielectric to form a gate structure on both the first and the second region,forming dielectric spacers covering the sidewalls of the gate structure, performing a replacement gate process on the first region comprising replacing the polysilicon layer on the first region by the first strained conductive layer.

The method according to the above, wherein selectively forming a first strained conductive layer comprises: depositing a first strained conductive layer overlying the metal gate layer on the first and the second region, removing the first strained conductive layer selectively to the metal gate layer on the second region.

The method according to the above, further comprising selectively forming a second strained conductive layer, overlying the metal layer on the second region, the second strained conductive layer exerting a selected strain on the metal gate layer, thereby inducing a second pre-determined work function shift (ΔWF2) in the first (as deposited) work function of the metal gate layer on the second region.

The method according to the above, further comprising selectively forming a third strained conductive layer overlying the gate structures and the spacers on at least one of the first and the second regions, the third strained conductive layer exerting a selected strain on the gate structures comprising the metal gate layer, thereby inducing a third pre-determined work function shift (ΔWF3) in the first (as deposited) work function of the metal gate layer, on at least one of the first and the second region, respectively.

The method according to the above, further comprising forming a dielectric layer in contact with the third strained conductive layer on both sides, thereby creating a dielectric-strained metal-dielectric stack (sandwich).

The method according to any of the above, wherein the first region is a NMOS region and the second region is a PMOS region.

The method according to any of the above, wherein the metal gate layer has a mid-gap as-deposited work function and the first pre-determined work function shift (ΔWF1) and the second pre-determined work function shift (ΔWF2) have opposite signs with respect to the mid-gap.

The method according to any of the above, further comprising performing a thermal treatment after depositing one of the first, the second or the third strained conductive layers, wherein the thermal treatment is selected to further modify in a pre-determined way the strain exerted on the metal gate layer and the work function shift induced in the first (as deposited) work function of the metal gate.

The method according to any of the above, wherein the first and the third strained conductive layer are made of the same material.

The method according to any of the above, wherein the substrate comprises Si, Ge, SiGe, SOI, GeOI, III-V materials and combinations thereof.

The method according to any of the above, wherein the gate dielectric layer comprises, SiO₂, SiON, high-k materials and combinations thereof.

The method according to any of the above, wherein the metal gate layer comprises a metal or a metal silicide.

The method according to any of the above, wherein the metal gate layer comprises at least one of the metals selected from the group of Mo, Ru, W, Al and co-sputtered Ni silicides.

The method according to any of the above, wherein the thickness of the metal gate layer is lower than 10nm.

The method according to any of the above, wherein the first strained conductive layer comprises metal carbides, metal nitrides, metal silicides or combinations thereof.

The method according to any of the above, wherein the first strained conductive layer is selected from the group consisting of TaxCy, WxCy, TixNy, TaxNy, TiAlN, TaAlN and combinations thereof, wherein x and y are real numbers 0<x, y ≤1.

The method according to any of the above, further comprising introducing one or more species selected from the group consisting of C, N and O into the first strained conductive layer.

The method according to the above, wherein the second strained conductive layer is selected from the group consisting of TaxCy, WxCy, TixNy, TaxNy, TiAlN, TaAlN and combinations thereof, wherein x and y are real numbers 0<x, y ≤1..

The method according to the above, wherein the third strained conductive layer comprises metal carbides, metal nitrides or combinations thereof.

The present invention also provides a semiconductor device obtainable with the method described in the above.

The present invention also provides a dual work function semiconductor device, comprising a first transistor on a first substrate region and a second transistor on a second substrate region, comprising: a gate dielectric, the gate dielectric of the first transistor having substantially the same composition and same thickness with the gate dielectric of the second transistor, and a metal gate layer having a first (as-deposited) work function that can be modified upon inducing strain thereon, overlying the gate dielectric, the metal gate layer of the first transistor having substantially the same composition and same thickness with the metal gate layer of the second transistor, the first transistor further comprises a first strained conductive layer overlying the metal gate layer, the first strained conductive layer exerts a selected strain on the metal gate layer, thereby inducing a first pre-determined work function shift (ΔWF1) in the first (as deposited) work function of the metal gate layer.

The semiconductor device of the above, wherein the second transistor further comprises a second strained conductive layer, overlying the metal layer, the second strained conductive layer exerts a selected strain on the metal gate layer, thereby inducing a second pre-determined work function shift (ΔWF2) in the first (as deposited) work function of the metal gate layer.

The semiconductor device of the above, further comprising selectively forming a third strained conductive layer overlying the gate structures and the spacers of at least one of the first and the second transistors, the third strained conductive layer exerts a selected strain on the gate structures comprising the metal gate layer, thereby inducing a third pre-determined work function shift (ΔWF3) in the first (as deposited) work function of the metal gate layer.

The semiconductor device of the above, wherein the first transistor further comprises a dielectric layer contacting both sides of the third strained conductive layer, thereby creating a dielectric-strained metal-dielectric stack (sandwich).

The semiconductor device of the above, wherein the first transistor is a NMOS transistor and the second transistor is a PMOS transistor.

The semiconductor device of the above, wherein the metal gate layer has a mid-gap as-deposited work function and the first pre-determined work function shift (ΔWF1) and the second pre-determined work function shift (ΔWF2) have opposite signs with respect to the mid-gap.

The semiconductor device of the above, wherein the first and the third strained conductive layer are made of the same material.

The semiconductor device of the above, wherein the substrate comprises Si, Ge, SiGe, SOI, GeOI, III-V materials and combinations thereof.

The semiconductor device of the above, wherein the gate dielectric layer comprises, SiO₂, SiON, high-k materials and combinations thereof.

The semiconductor device of the above, wherein the metal gate layer comprises a metal or a metal silicide.

The semiconductor device of the above, wherein the metal gate layer comprises at least one of the metals selected from the group of Mo, Ru, W, Al and co-sputtered Ni silicides.

The semiconductor device of the above, wherein the thickness of the metal gate layer is lower than 10nm.

The semiconductor device of the above, wherein the first strained conductive layer comprises metal carbides, metal nitrides, metal silicides or combinations thereof.

The semiconductor device of the above, wherein the first strained conductive layer is selected from the group consisting of TaxCy, WxCy, TixNy, TaxNy, TiAlN, TaAlN and combinations thereof, wherein x and y are real numbers 0<x, y ≤1.

The semiconductor device of the above, wherein the first strained conductive layer further comprises one or more species selected from the group consisting of C, N and O.

The semiconductor device of the above, wherein the second strained conductive layer is selected from the group consisting of TaxCy, WxCy, TixNy, TaxNy, TiAlN, TaAlN and combinations thereof, wherein x and y are real numbers 0<x, y ≤1.

### Brief Description of the Drawings

All drawings are intended to illustrate some aspects and embodiments of the present invention. The drawings described are only schematic and are non-limiting.
Fig. 1 represents the calculated work function shift (eV) as function of the strain (%) applied on Ta(110) layers, in the case of: ◆ (diamond) uniaxial strain; ■ (square) biaxial strain.
Fig. 2 represents the influence of the thermal treatment on the stress (dynes/cm2) of a TiN layer on Si: (1) as deposited (2) pre-annealed (300°C-650°C)(3) RTP-annealed (650°C) (4) spike annealed (1050°C).
Fig. 3 represents the channel stress (MPa) as a function of the film intrinsic stress (GPa) for: ◆ (diamond) metal filling (strained metal layer) ; ■ (square) work function (WF) metal with a thickness of 5nm ▲
(triangle) contact stop etch layer (CESL) with a thickness of 50nm.
Fig. 4 represents the different process steps in the manufacturing of a semiconductor device comprising at least one strained conductive layer.
Fig. 5 represents schematically a semiconductor device comprising a first (4) and a second (10) strained conductive layer.

### Detailed Description of Certain Inventive Embodiments

The present invention will be described with respect to particular embodiments and with reference to certain drawings but the invention is not limited thereto but only by the claims. Any reference signs in the claims shall not be construed as limiting the scope. The drawings described are only schematic and are non-limiting. In the drawings, the size of some of the elements may be exaggerated and not drawn on scale for illustrative purposes.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

The terms deeper or higher are used to denote the relative position of elements in a substrate. With deeper is meant that these elements are more distant from a main surface of the substrate from which side the measurement is to be performed.

State of the art describes strained layers as well as other strain enhancing techniques (e.g. strained silicon on insulator (SSOI), or SiGe re-growth) that are used in CMOSFET (complementary metal-oxide-semiconductor field effect transistors) technology for enhancing device performance. The induced strain can propagate into the channel, modifying the band diagram and leading to an increase the drive current. The strained layers are either removed, while their benefit is kept due to stress memorization techniques (SMT), or they can be kept and used as e.g. contact etch-stop layer (CESL).

Various embodiments of the present invention include a method for manufacturing a dual work function semiconductor device using strained conductive layers for work function tuning.

The invention will now further be described by a detailed description of several particular embodiments of the invention. It is clear that other embodiments of the invention can be configured according to the knowledge of persons skilled in the art without departing from the true spirit or technical teaching of the invention.

Where, herein, a specific chemical name or formula is given, the material may include non-stoichiometric variations of the stoichiometrically exact formula identified by the chemical name. Lack of numerical subscript by an element in the formula stoichiometrically signifies the number one (1). Variations in the range plus/minus 20% of the exact stoichiometric number are comprised in the chemical name or formula, for the present purposes. Where an algebraic subscript is given, then variations in the range of about plus/minus 20% are comprised relative to the value of each subscript. Such varied values do not necessarily sum to a whole number and this departure is contemplated. Such variations may occur due to either intended selection and control of the process conditions, or due to unintended process variations.

In a first aspect of the current invention a method for manufacturing a dual work function semiconductor device is disclosed, comprising
- providing a substrate with a first and a second region,
- forming a gate dielectric overlying the first and the second region,
- forming a metal gate layer overlying the gate dielectric, the metal gate layer having a first (as-deposited) work function that can be modified upon inducing strain thereon,
- selectively forming a first strained conductive layer, overlying the metal gate layer on the first region, the first strained conductive layer exerting a selected strain on the metal gate layer, thereby inducing a first pre-determined work function shift (ΔWF1) in the first (as-deposited) work function of the metal gate layer on the first region.

The gate dielectric can comprise one or more layers of dielectric materials, e.g. Si02, SiON or high-k dielectric materials.

The gate electrode comprises a metal gate layer overlying the gate dielectric and one or more conductive layers overlying the metal gate layer. The work function of the metal gate layer in contact with the gate dielectric determines the threshold voltage of the device. The metal gate layer can comprise a metal or a co-sputtered metal silicide.

The conductive layers overlying the metal gate layers can be made of metal, polysilicon or silicide. The physical characteristics of the conductive layers (e.g. material, thickness, deposition method) are selected to exert a selected strain on the metal gate layer, thereby inducing a pre-determined work function shift in the work function of the metal gate layer. Advantageously, the conductive layers lower the contact resistance of the gate electrode.

An advantage of the method is that the effective work function of the metal gate layer is modulated through the introduction of a strained conductive layer. Another benefit of the method is the mobility enhancement introduced by the strained conductive layer due to the stress applied on the channel.

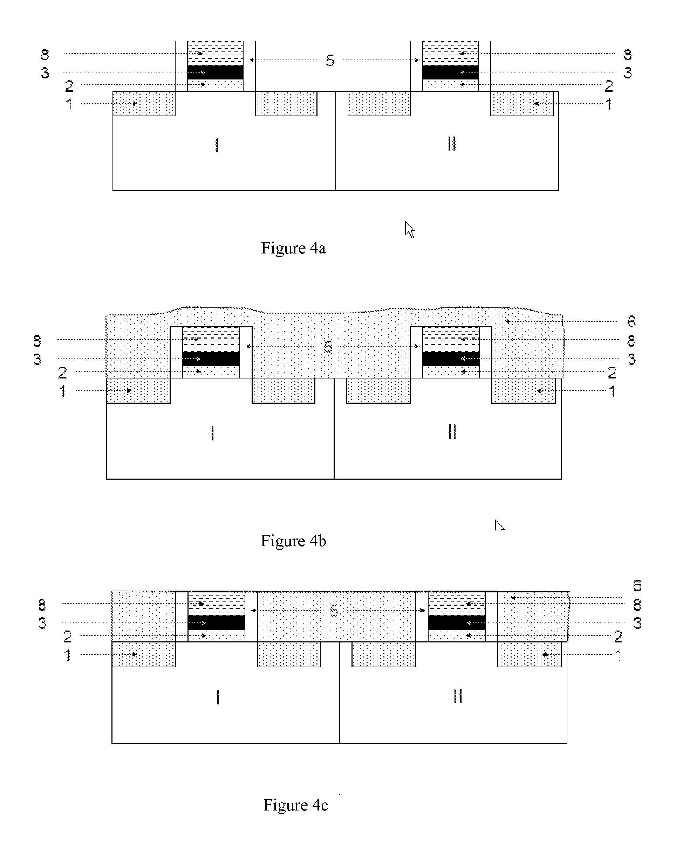

One embodiment of the first aspect of the current invention discloses selectively forming a first strained conductive layer by a gate-last approach as schematically represented in Figure 4(a)-(e) comprising:
- depositing a layer of polysilicon (8) overlying the metal gate layer (3) on the first and the second region
- patterning the polysilicon (8), the metal gate (3) layer and the gate dielectric (2) to form a gate structure on both the first and the second region,
- forming dielectric spacers (5) covering the sidewalls of the gate structure
- performing a replacement gate process on the first region comprising replacing the polysilicon layer (8) on the first region by the first strained conductive layer (4).

Another embodiment of the first aspect of the current invention discloses the step of selectively forming a first strained conductive layer by a "gate-first" approach comprising
- depositing a first strained conductive layer overlying the metal gate layer on the first and the second region
- removing the first strained conductive layer selectively to the metal gate layer on the second region.

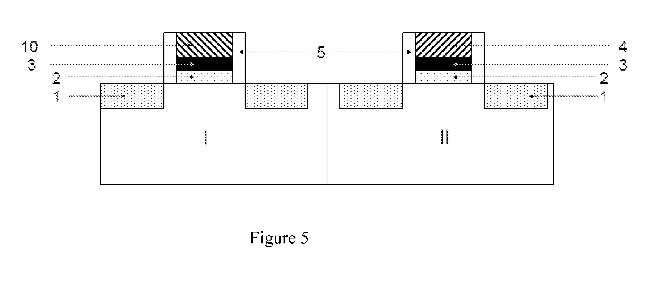

An embodiment of the first inventive aspectdiscloses a method for manufacturing a dual work function semiconductor device further comprising selectively forming a second strained conductive layer (10) , overlying the metal layer (3) on the second region, the second strained conductive layer exerting a selected strain on the metal gate layer, thereby inducing a second pre-determined work function shift (ΔWF2) in the first (as deposited) work function of the metal gate layer on the second region. This embodiment is schematically represented in Figure 5.

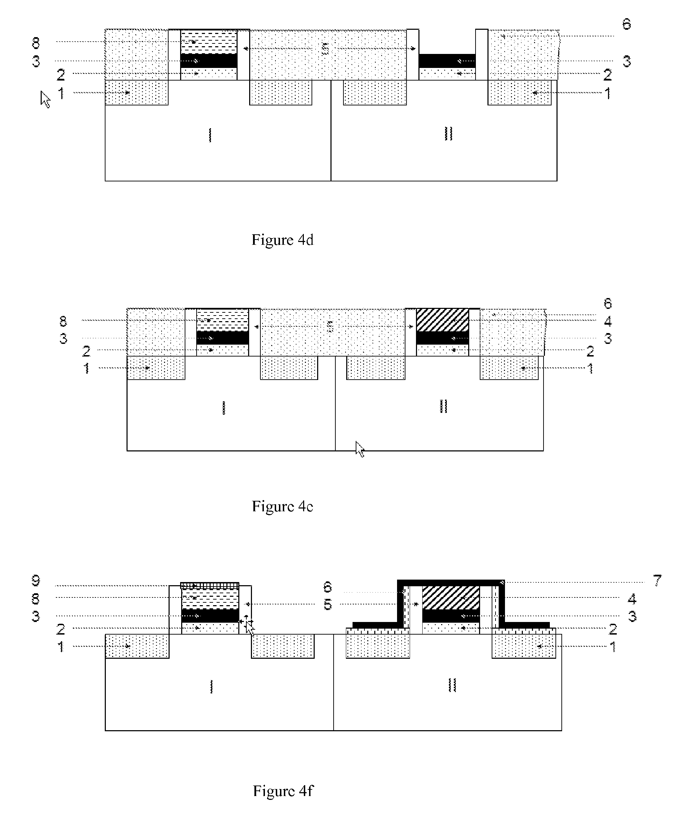

Another embodiment of the first aspect discloses a method for manufacturing a dual work function semiconductor device, further comprising selectively forming a third strained conductive layer (7) overlying the gate structures and the spacers on at least one of the first and the second regions, the third strained conductive layer exerting a selected strain on the gate structures comprising the metal gate layer (3), thereby inducing a third pre-determined work function shift (ΔWF3) in the first (as deposited) work function of the metal gate layer, on at least one of the first and the second region, respectively. This embodiment is schematically represented in Figure 4(f).

In one specific embodiment of the first aspect of the current invention, an integration scheme is disclosed wherein a third strained conductive layer (7) is deposited overlying the gate structures and the spacers. The integration scheme comprises the following processes:
(1) -standard CMOS processing including active area and shallow trench isolation (STI) definition and well implantation;
(2) -forming a gate dielectric e.g. SiO₂, SiON or any high-k material (with a dielectric constant k > kSiO₂);
(3) -gate electrode formation and patterning of the gate structures; the gate electrode comprises a metal layer (e.g. Ta, TaN, TaC) or a polysilicon layer to be converted to fully silicided gate (FUSI).
(4) junction formation, spacer definition, source/drain (S/D) rapid thermal anneal (RTA) and S/D silicidation
(5) third strained conductive layer formation overlying the gate structures and the spacers. The third strained conductive layer can comprise e.g. TiN, W.
(6) selective removal of the third strained conductive layer from one of the regions (either NMOS or PMOS). The third strained conductive layer can be kept either on NMOS or on PMOS, depending on the as deposited work function of the metal gate layer and the stress required to modify the as deposited work function with a pre-determined value (shift).

The type (tensile/compressive) and the intrinsic level of strain which determines the as-deposited work function is a function of the type of metal used, the thickness of the metal layer, the deposition method (e.g. ALD, CVD, AVD, PVD) and temperature budget of the different thermal treatments. Preferably the thickness of the metal layer is between about 0.5 to 10nm, most preferably between about 5 nm to 10nm.

Advantageously, the third strained conductive layer (7) can be sandwiched in between two dielectric layers, which improves the adhesion of the third strained conductive layer and avoids the leakage path generation.

In another embodiment of the first aspect of the current invention elements like C, N, or O can be incorporated during deposition or post-deposition (e.g. by implantation, plasma-doping) into the first/second/third strained conductive layer.

In one embodiment of the first aspect of the current invention a method is disclosed further comprising performing a thermal treatment after depositing one of the first (4), the second (10) or the third (7) strained conductive layers, wherein the thermal treatment is selected to further modify in a pre-determined way the strain exerted on the metal gate layer (3) and the work function shift induced in the first (as deposited) work function of the metal gate.

In a second aspect of the current invention a dual work function semiconductor device is disclosed, comprising
- a first transistor on a first substrate region and a second transistor on a second substrate region, comprising:
- a gate dielectric (2), the gate dielectric of the first transistor having substantially the same composition and same thickness with the gate dielectric of the second transistor, and
- a metal gate layer (3) having a first (as-deposited) work function that can be modified upon inducing strain thereon, overlying the gate dielectric, the metal gate layer of the first transistor having substantially the same composition and same thickness with the metal gate layer of the second transistor,
- the first transistor further comprises a first strained conductive layer (4) overlying the metal gate layer, the first strained conductive layer exerts a selected strain on the metal gate layer, thereby inducing a first pre-determined work function shift (ΔWF1) in the first (as deposited) work function of the metal gate layer.

In one embodiment of the second aspect, the second transistor further comprises a second strained conductive layer (10), overlying the metal layer (3), the second strained conductive layer exerts a selected strain on the metal gate layer, thereby inducing a second pre-determined work function shift (ΔWF2) in the first (as deposited) work function of the metal gate layer.

In another embodiment of the second aspect, a semiconductor device is disclosed further comprising selectively forming a third strained conductive layer (7) overlying the gate structures and the spacers of at least one of the first and the second transitors, the third strained conductive layer exerts a selected strain on the gate structures comprising the metal gate layer, thereby inducing a third pre-determined work function shift (ΔWF3) in the first (as deposited) work function of the metal gate layer.

In a further embodiment of the second aspect the first/second/third strained conductive layer further comprises one or more species selected from the group consisting of C, N and O.

In yet another embodiment of the second aspect, the first transistor further comprises a dielectric layer contacting both sides of the third strained conductive layer, thereby creating a dielectric-strained metal-dielectric stack (sandwich).

In one embodiment of the current invention, the first transistor is a NMOS transistor and the second transistor is a PMOS transistor.

In another embodiment of the current invention, the first transistor is a PMOS transistor and the second transistor is a NMOS transistor.

In yet another embodiment of the current invention, the metal gate layer (3) has a mid-gap as-deposited work function and the first pre-determined work function shift (ΔWF1) and the second pre-determined work function shift (ΔWF2) have opposite signs with respect to the mid-gap.

In one particular embodiment of the current invention, the first strained conductive layer (4) and the third strained conductive layer (7) are made of the same material.

In any of the embodiments of the current invention the substrate comprises Si, Ge, SiGe, SOI, GeOI, III-V materials and combinations thereof.

In any of the embodiments of the current invention the gate dielectric layer (2) comprises, SiO₂, SiON, high-k materials and combinations thereof.

In any of the embodiments of the current invention the metal gate layer (3) comprises a metal or a co-sputtered metal silicide.

In various embodiments of the current invention the metal gate layer (3) comprises at least one of the metals selected from the group of Mo, Ru, W, Al and co-sputtered Ni silicides. Advantageously, the thickness of the metal gate layer is lower than 10nm.

In embodiments of the current invention the first strained conductive layer (4) comprises metal carbides, metal nitrides, metal silicides or combinations thereof.

In a particular embodiment of the current invention, the first strained conductive layer is selected from the group consisting of TaxCy, WxCy, TixNy, TaxNy, TiAlN, TaAlN and combinations thereof, wherein x and y are real numbers 0<x, y ≤1.

In another embodiment of the current invention the second strained conductive layer (10) is selected from the group consisting of TaxCy, WxCy, TixNy, TaxNy, TiAlN, TaAlN and combinations thereof, wherein x and y are real numbers 0<x, y ≤1..

In yet another embodiment of the current invention, the third strained conductive layer (7) comprises metal carbides, metal nitrides or combinations thereof.

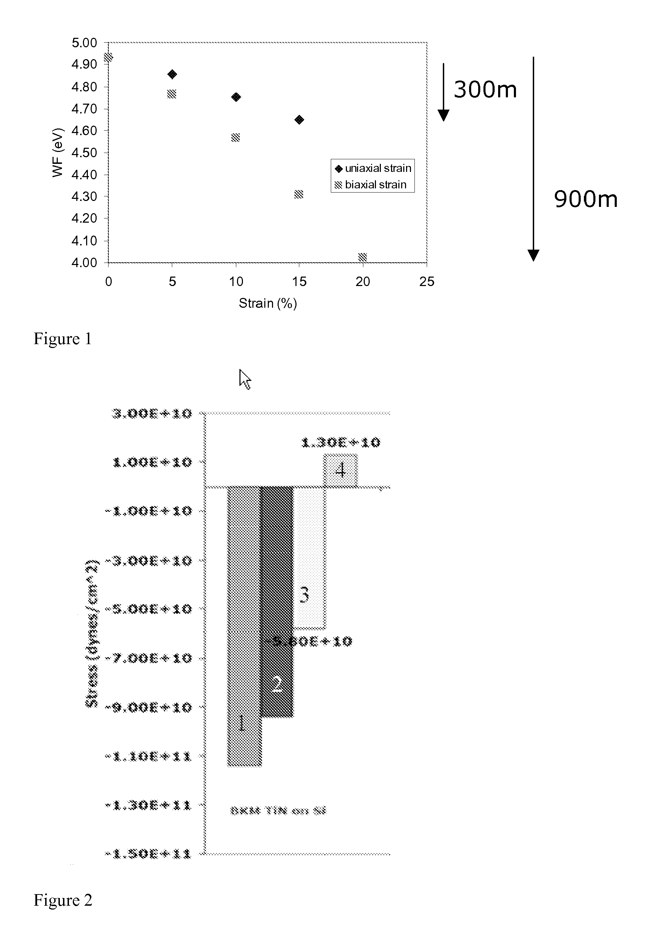

Simulation data have shown that when inducing a certain strain on pure Ta (110) layers a work function shift is obtained. It was surprisingly found that a strain of about 5-10% induces a work function (WF) shift of about 300 meV, which is enough to switch the device from e.g. a PMOS-type to a NMOS-type (Figure 1). In an integration route, depending on the metal gate layer (3) of choice the amount of strain needed to induce a similar work function shift can be determined in advance.

As shown in Figure 2 different thermal treatments can further modulate the existing strain, leading to variations up to 11GPa in TiN layers on Si depending on the temperature budget applied.

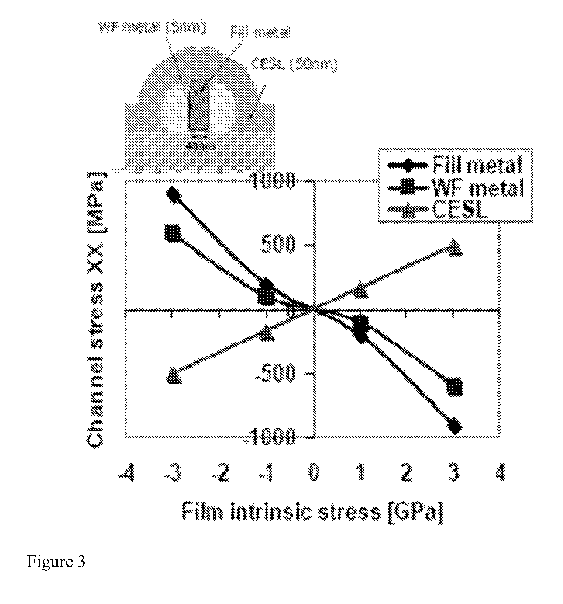

An additional benefit of employing strained metal layers as disclosed is the channel stress modulation as shown in Figure 3.

Fig. 4 represents the different process steps in the manufacturing of the semiconductor device containing at least one strained conductive layer.: (a) upon definition of the metal inserted polysilicon (MIPS) gate and the definition of the spacers; (b) dielectric deposition (6) prior to CMP (chemical mechanical polishing); (c) upon CMP of the dielectric layer (6); (d) upon selective removal of one of the polysilicon gates (8); (e) upon filling and CMP of the first strained conductive layer (4); (f) upon deposition of the third strained conductive layer (7) overlying a thin buffer dielectric layer (6').

The metal gate layer (3) has an as deposited (intrinsic) work function which depends on the type metal, the thickness of the metal layer, the deposition method and the temperature budget applied. The metal gate layer can comprise Mo, Ru, W, Al, co- sputtered silicides (Ni and Si).

The gate dielectric (2) can comprise Si02, SiON or any high-k material. The choice of high-k might have an influence on the stress behavior of the high-k/metal gate stack.

As shown in figure 4(a)-(e), a first strained conductive layer (4) is deposited upon the metal gate layer (3) by a replacement gate process, in order to avoid high temperature steps which may modify the strain.

The first strained conductive layer (4) can comprise metal carbides or metal nitrides like TaxCy, WxCy, TixNy, TaxNy. The material, the thickness and method of deposition of the first strained conductive layer are chosen in such way that a pre-determined level of strain is induced in the metal gate layer (3) and additionally the adhesion with the metal gate layer is compatible with further processing.

The replacement gate process further comprises dielectric (e.g. Si-oxide) deposition and dielectric chemical mechanical polishing (CMP) as shown schematically in Figure 4(b and c), followed by polysilicon (8) gate wet removal in the second region while the first region is masked/protected (Figure 4(d)) and the forming of the first strained conductive layer (4) as shown in Figure 4(e).

In a particular embodiment, when the replacement gate is used on the PMOS region, a FUSI gate can be formed on the NMOS region.

Additionally, upon spacer definition a dielectric buffer layer (6) can be deposited followed by the deposition of a third strained conductive (TiN, W) layer.

Figure 5 represents schematically PMOS metal gate with a first strained conductive layer (4) and NMOS metal gate with a second strained conductive layer (10).

The foregoing description details certain embodiments of the invention. It will be appreciated, however, that no matter how detailed the foregoing appears in text, the invention may be practiced in many ways. It should be noted that the use of particular terminology when describing certain features or aspects of the invention should not be taken to imply that the terminology is being re-defined herein to be restricted to including any specific characteristics of the features or aspects of the invention with which that terminology is associated.

While the above detailed description has shown, described, and pointed out novel features of the invention as applied to various embodiments, it will be understood that various omissions, substitutions, and changes in the form and details of the device or process illustrated may be made by those skilled in the technology without departing from the spirit of the invention.

## Claims

1. A method for manufacturing a dual work function semiconductor device comprising: providing a substrate with a first and a second region, forming a gate dielectric overlying the first and the second region, forming a metal gate layer overlying the gate dielectric, the metal gate layer having a first (as-deposited) work function that can be modified upon inducing strain thereon, selectively forming a first strained conductive layer, overlying the metal gate layer on the first region, the first strained conductive layer exerting a selected strain on the metal gate layer, thereby inducing a first pre-determined work function shift (ΔWF1) in the first (as-deposited) work function of the metal gate layer on the first region.

2. The method according to claim 1, wherein selectively forming a first strained conductive layer comprises: depositing a layer of polysilicon overlying the metal gate layer on the first and the second region, patterning the polysilicon, the metal gate layer and the gate dielectric to form a gate structure on both the first and the second region, forming dielectric spacers covering the sidewalls of the gate structure, performing a replacement gate process on the first region comprising replacing the polysilicon layer on the first region by the first strained conductive layer.

3. The method according to claim 1, wherein selectively forming a first strained conductive layer comprises: depositing a first strained conductive layer overlying the metal gate layer on the first and the second region, removing the first strained conductive layer selectively to the metal gate layer on the second region.

4. The method according to any preceding claim, further comprising selectively forming a second strained conductive layer, overlying the metal layer on the second region, the second strained conductive layer exerting a selected strain on the metal gate layer, thereby inducing a second pre-determined work function shift (ΔWF2) in the first (as deposited) work function of the metal gate layer on the second region.

5. The method according to any preceding claim, further comprising selectively forming a third strained conductive layer overlying the gate structures and the spacers on at least one of the first and the second regions, the third strained conductive layer exerting a selected strain on the gate structures comprising the metal gate layer, thereby inducing a third pre-determined work function shift (ΔWF3) in the first (as deposited) work function of the metal gate layer, on at least one of the first and the second region, respectively.

6. The method according to claim 5, further comprising forming a dielectric layer in contact with the third strained conductive layer on both sides, thereby creating a dielectric-strained metal-dielectric stack (sandwich).

7. The method according to any of claims 4 to 6, wherein the metal gate layer has a mid-gap as-deposited work function and the first pre-determined work function shift (ΔWF1) and the second pre-determined work function shift (ΔWF2) have opposite signs with respect to the mid-gap.

8. The method according to any preceding claim, further comprising performing a thermal treatment after depositing one of the first, the second or the third strained conductive layers, wherein the thermal treatment is selected to further modify in a pre-determined way the strain exerted on the metal gate layer and the work function shift induced in the first (as deposited) work function of the metal gate.

9. The method according to any of the claims 5 to 8, wherein the first and the third strained conductive layer are made of the same material.

10. The method according to any preceding claim, wherein the metal gate layer comprises a metal or a metal silicide, or the metal gate layer comprises at least one of the metals selected from the group of Mo, Ru, W, Al and co-sputtered Ni silicides.

11. The method according to any preceding claim, wherein the thickness of the metal gate layer is lower than 10nm.

12. The method according to any preceding claim, wherein the first strained conductive layer comprises metal carbides, metal nitrides, metal silicides or combinations thereof, or
the first strained conductive layer is selected from the group consisting of TaxCy, WxCy, TixNy, TaxNy, TiAlN, TaAlN and combinations thereof, wherein x and y are real numbers 0<x, y ≤1, or
the method further comprises introducing one or more species selected from the group consisting of C, N and O into the first strained conductive layer.

13. The method according to any preceding claim, wherein the second strained conductive layer is selected from the group consisting of TaxCy, WxCy, TixNy, TaxNy, TiAlN, TaAlN and combinations thereof, wherein x and y are real numbers 0<x, y ≤1.

14. A dual work function semiconductor device obtainable by the method of any of the claims 1 to 13.

15. A dual work function semiconductor device according to claim 14, wherein the first transistor is a NMOS transistor and the second transistor is a PMOS transistor.
